Europäisches Patentamt

European Patent Office

Office européen des brevets

(19)

(11) Publication number: **0 064 819**
**B1**

# EUROPEAN PATENT SPECIFICATION

(12)

(45) Date of publication of patent specification: **05.02.86**

(51) Int. Cl.⁴: **H 03 D 3/00**

(21) Application number: **82301963.3**

(22) Date of filing: **16.04.82**

(54) An FM signal demodulation system.

(30) Priority: **28.04.81 JP 63384/81**
**28.04.81 JP 63385/81**

(43) Date of publication of application:
**17.11.82 Bulletin 82/46**

(45) Publication of the grant of the patent:
**05.02.86 Bulletin 86/06**

(84) Designated Contracting States:
**DE FR GB**

(56) References cited:
**EP-A-0 048 661**
**US-A-4 035 730**
**US-A-4 066 972**
**US-A-4 079 330**
**US-A-4 101 837**

**ARCHIV DER ELEKTRISCHEN ÜBERTRAGUNG,
vol. 33, no. 2, February 1979, Stuttgart, F. ABEL
"Möglichkeiten und Grenzen der Verbesserung
des Schnellwertverhaltens von FM-
Demodulatoren"**

(73) Proprietor: **Oki Electric Industry Company,
Limited
7-12, Toranomon 1-chome Minato-ku
Tokyo 105 (JP)**

(73) Proprietor: **NIPPON HOSO KYOKAI
No- 2-1, Jinnan 2-chome Shibuya-ku
Tokyo (JP)**

(72) Inventor: **Ohta, Tomozo c/o Oki Electric
Industry Co., Ltd
7-12, Toranomon 1-chome
Minato-ku Tokyo (JP)**
Inventor: **Tsutsumi, Yoshio Oki Electric Industry
Co., Ltd.
7-12, Toranomon 1-chome
Minato-ku Tokyo (JP)**
Inventor: **Konishi, Yoshihiro c/o Nippon Hoso
Kyokai
Technical Research Laboratories
10-11, Kinuta 1-chome Setagaya-ku Tokyo (JP)**

(74) Representative: **George, Sidney Arthur et al
GILL JENNINGS & EVERY 53-64 Chancery Lane
London WC2A 1HN (GB)**

Courier Press, Leamington Spa, England.

# 0 064 819

## Description

This invention relates to a frequency modulation (FM) signal demodulation system, and in particular relates to such a system which improves the noise characteristics of the demodulated FM signal.

A prior FM signal demodulation circuit is a frequency demodulation circuit having an inductance (L) and a capacitance (C), or a delay line. In this case, the signal-to-noise ratio (S/N) of the demodulated signal for the ratio (C/N) in which C is the carrier signal power and N is the thermal noise power of an input signal is given by

$$S/N = C/N \ (FI)$$

where FI is a constant. In general, therefore, the value S/N is proportional to C/N. However, if the value C/N is less than a predetermined threshold level, the equation is not satisfied, but the value S/N is considerably degraded. The threshold level is usually approximately 10 dB. In order to improve the value C/N, a bandpass filter is utilized at the input of the demodulator in order to restrict the bandwidth of the input signal and to reduce the thermal noise.

In a television signal transmission system operating via a satellite relay system, FM transmission has been used. The received signal level in a satellite communication system is usually around the threshold level, due to restriction of the transmission power of the satellite, the attenuation and/or stability of the transmission path, and/or the apparatus at the earth station. Accordingly, when a received signal level is decreased slightly for some reason, that signal level becomes lower than the threshold level, and then the picture quality produced by the television signal is considerably degraded by spike noise which is peculiar to television transmissions, and/or it becomes even impossible to reproduce a picture signal.

Accordingly, it is desirable to reduce the sensitivity to spike noise, and/or the sensitivity to a reduction in the reception level of the television signal, in order to improve the picture quality. In particular, in the case of a direct satellite broadcasting system in which a satellite transmitter sends a picture signal directly to consumers' simple television receivers, improvement of the noise characteristics is very important.

United States Patent No. 4 101 837 discloses an FM demodulator which includes a frequency discriminator which demodulates the FM signal, and an adaptive bandpass filter connected between the FM signal input and the frequency discriminator. The bandwidth of the adaptive bandpass filter is controlled by a signal which is produced by filtering and amplifying the demodulated video signal. The filter thereby tracks the instantaneous frequency of the FM signal.

It is an object of the present invention to provide an FM demodulator in which an adaptive bandpass filter has a variable bandwidth about a fixed centre frequency, the bandwidth being variable in response to the signal-to-noise ratio of the demodulated signal.

According to the invention, there is provided an FM signal demodulation system comprising an input to receive an FM signal; detection means for providing a control signal dependent upon the level of the FM signal; an adaptive bandpass filter coupled to the input, the bandwidth of which filter is controlled by the control signal from the detection means; and a frequency discriminator coupled to the output of the adaptive bandpass filter for demodulating the FM signal to provide a demodulated signal; characterised in that the adaptive bandpass filter has a fixed centre frequency; in that the detection means detects the signal-to-noise ratio of the demodulated signal to provide the control signal; and in that the adaptive bandpass filter responds to the signal-to-noise ratio detected by the detection means so that the bandwidth is narrow when said signal-to-noise ratio is low, and the bandwidth is wide when said signal-to-noise ratio is high.

In a preferred embodiment, the detection means detects the level of a colour sub-carrier component of a television signal.

Embodiments of the invention will now be described, by way of example, with reference to the accompanying drawings, in which:

Figure 1 is a block diagram of an FM signal demodulation system according to the present invention;

Figure 2 is a curve showing the relationship between input signal level and the value of S/N of the demodulated signal;

Figure 3 shows typical characteristics of an adaptive bandpass filter for explanation of the operation of the present invention;

Figure 4 shows further filter characteristics for explanation of the operation of the present invention;

Figure 5 is a circuit diagram of an adaptive bandpass filter for use in the system of the present invention;

Figure 6 is a curve showing the relationship between the bandwidth of the adaptive bandpass filter and improvement in the threshold level;

Figure 7 is a curve showing the relationship between the modulation index $m_f$ and the improvement in the threshold level;

Figure 8 is a curve showing the relationship between the bandwidth of the adaptive bandpass filter and the improvement in the threshold level, in which no improvement is achieved; and

Figure 9 shows bandwidth versus input signal level characteristics of the adaptive bandpass filter.

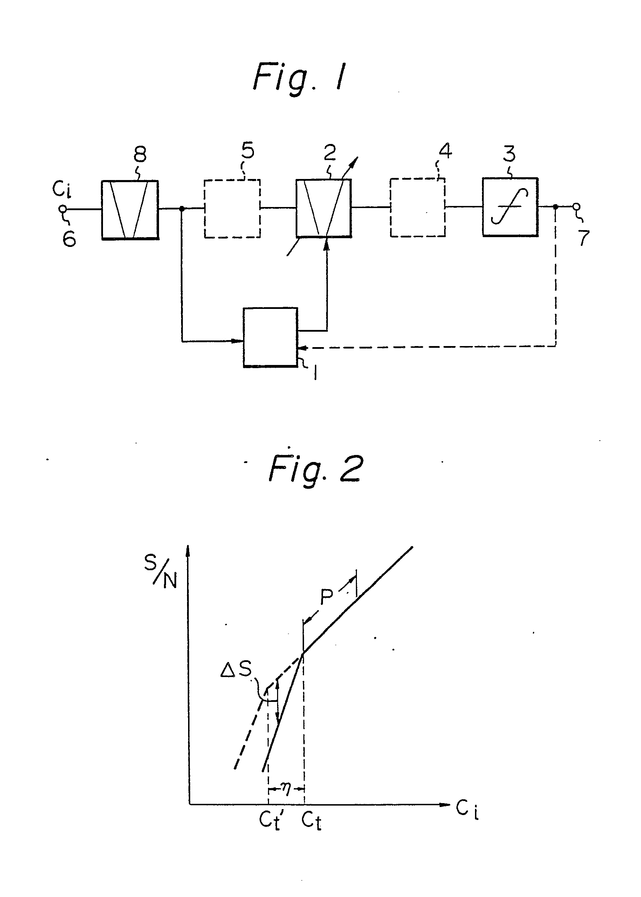

Figure 1 is a block diagram of a demodulation system according to the present invention. The system

2

comprises a signal level detector or C/N detector 1 which detects the signal level of a television signal in a receiver. In the embodiment, the signal level is detected in an intermediate frequency (IF) portion of the receiver, before demodulation. A variable or adaptive bandpass filter 2 has a bandwidth which is adjustable. A frequency discriminator 3 having an inductance (L) and a capacitance (C), or a delay line, demodulates the FM signal. Circuits 4 and 5 include an amplifier, an amplitude limiter, etc. The FM signal is fed in at an input terminal 6, and the demodulated television signal is fed out from an output terminal 7. A reference bandpass filter 8 having a fixed bandwidth ($B_0$) is connected to the input terminal 6. It is assumed that the input signal to the input terminal 6 is in the intermediate frequency range (70 MHz to 140 MHz), and that that signal is frequency converted, in an external circuit (not shown), from a high radio-frequency signal received from a satellite station.

An input signal $C_i$ at the input terminal 6 is applied to the reference bandpass filter 8 which has a fixed bandwidth $B_0$, so that the bandwidth of the input signal $C_i$ is restricted by the filter 8, and some noise energy is thereby removed.

The output of the bandpass filter 8 is applied to the signal level detector 1, and is applied to the adaptive bandpass filter 2 through the circuit 5. The signal level detector 1 detects the level of the signal, or the value C/N at the output of the bandpass filter 8.

The bandwidth of the adaptive bandpass filter 2 is controlled according to the signal level detected by the signal level detector 1, so that the bandwidth becomes narrow when the signal level is around or lower than the threshold level, according to the modulation index of some component of a television signal. Thus, the bandwidth of a television signal is determined by the bandwidth of the adaptive bandpass filter 2. The output of the adaptive bandpass filter 2 is applied to the discriminator 3 through the circuit 4, and then, the demodulated television signal is applied to the output terminal 7. The signal level detector 1 controls the bandwidth of the filter 2, for instance, according to the signal power of the total television signal power, or some noise component.

The bandwidth $B_0$ of a reception system is determined as follows:

$$B_0 = 2(\Delta f + f_h)$$

in order to obtain enough energy of the modulated signal, and keep the distortion of the demodulated signal to the desired low level, where $\Delta f$ is the highest frequency shift of an input television signal, and $f_h$ is the highest modulation frequency of the television signal. It should be appreciated that the bandwidth is a little wider than that value $B_0$, considering the fluctuation of the carrier frequency.

The value C/N (ratio of the carrier power to the noise power) in this case is $C_i/(kB_0)$ at the input of the discriminator 3, where k is a constant.

If there is no adaptive bandpass filter 2, or the bandwidth of said adaptive bandpass filter 2 is wider than that of the reference bandpass filter 8, the circuit of Fig. 1 operates similarly to a conventional Fm demodulation system.

Fig. 2 shows the relation between the input carrier level $C_i$ and the value S/N of the demodulated signal, and it should be noted in Fig. 2 that the value S/N is deteriorated as the value $C_i$ is decreased, and when the value $C_i$ is decreased lower than the threshold level ($C_i = C_t$), the value S/N is decreased rapidly. The threshold level corresponds approximately to C/N = 10 dB.

In normal reception operation, the reception signal level is higher than that threshold level $C_t$ by several dB, and is in the range shown by the symbol P in Fig. 2. In this case, the value S/N is obtained by the equation below:

$$S/N = (3/2)(\Delta f/f_h)^2 (B_0/f_h)(C_i/N)$$

where $N = kB_0$, and k is a constant. In some circumstances, the carrier level $C_i$ is decreased lower than that threshold level $C_t$, and that situation occurs often when a communication apparatus is simple.

When the carrier level $C_i$ is higher than the threshold level $C_t$, the picture quality of a television picture which is transmitted through an FM system, depends upon the thermal noise, the nonlinear distortion of the reception system, and the bandwidth $B_0$ of the demodulation system. When the bandwidth $B_0$ is narrow, the thermal noise is decreased, but the distortion is increased.

On the other hand, when the carrier level $C_i$ is the same as or lower than the threshold level $C_t$, and the bandwidth $B_0$ is approximately $2(\Delta f + f_h)$, the picture quality is influenced more by the thermal noise, but is less influenced by the non-linear distortion. The deterioration of the picture quality by the non-linear distortion is masked by the deterioration by the thermal noise. When the carrier level $C_i$ is lower than the threshold level, the picture quality is deteriorated suddenly, and a picture is almost not recognizable because of the spike noise. Therefore, when the carrier level is equal to or lower than the threshold level, the picture quality depends upon the thermal noise, and if the thermal noise characteristics are improved, the picture quality is improved considerably.

The present invention improves the ratio C/N of the input signal to a discriminator by controlling an adaptive bandpass filter, and improves the picture quality of a television signal.

Now, the present invention is described theoretically in more detail.

It is assumed that the highest modulation frequency $f_h$ is modulated with the highest frequency shift $\Delta f$

3

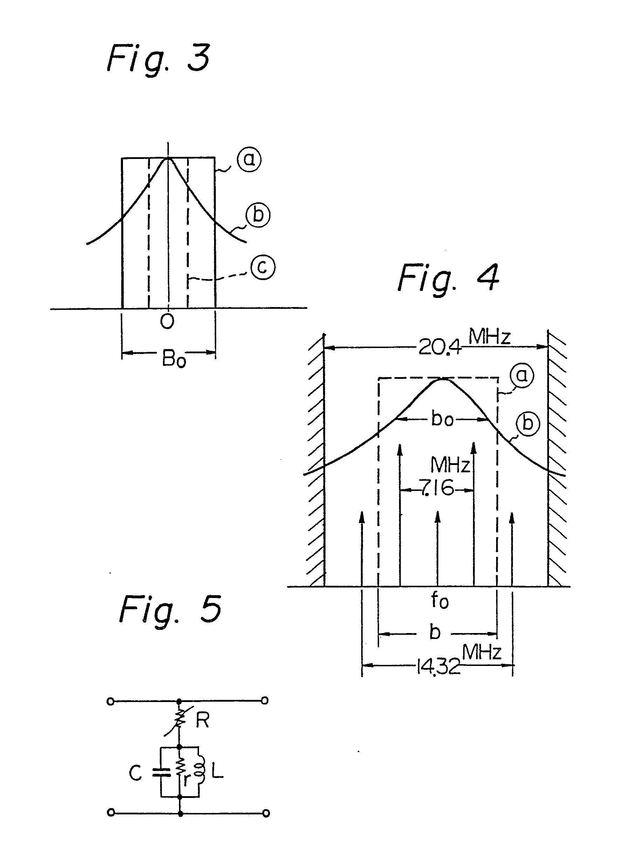

through the FM modulation system. The modulation index $m_f$ is $m_f = \Delta f / f_h'$. It is assumed that the reference bandpass filter 8 has the bandwidth $B_0 = 2(\Delta f + f_h')$, and that bandpass filter has flat characteristics in the pass band and infinite attenuation out of the passband as shown by the curve (a) in Fig. 3. The signal power $P_0$ at the input of the reference bandpass filter of the FM signal which is modulated by the frequency $f_h'$ is shown below:

$$P_0 = \sum_{p=-n}^{n} J_p^2(m_f) = J_0^2(m_f) + 2J_1^2(m_f) + 2J_2^2(m_f) + '''' \tag{1}$$

where $J_i(m_f)$ means a Bessel function.

As the reference bandpass filter restricts the bandwidth to $B_0$, and therefore, the component satisfying $nf_h' < B_0/2$ is transmitted and appears at the output of the reference bandpass filter. The output power of the bandpass filter is designated $P_0'$.

On the other hand, the noise power $N_0$ of the reference bandpass filter 8 is proportional to the bandwidth, and is expressed below:

$$N_0 = kB_0 \tag{2}$$

where k is a constant. Therefore, the ratio C/N at the output of the reference bandpass filter is:

$$C/N = P_0'/N_0$$

Next, the adaptive bandpass filter 2 has the power transfer function T(f), and the symmetrical passband characteristics as shown by the symbol (b) in Fig. 3. The horizontal axis in Fig. 3 is the normalized frequency in which the difference from the center frequency is shown, and T(0)=1 is satisfied at f=0.

The output signal power $P_T$ of the adaptive bandpass filter 2 is shown below:

$$P_T = \sum_{p=-n}^{n} J_p^2(m_f)T(pf_h')$$

$$= J_0^2(m_f) + 2J_1^2(m_f)T(f_h') + 2J_2^2(m_f)T(2f_h') + '''''''$$

$$+ 2J_n^2(m_f)T(nf_h') \tag{3}$$

where $nf_h' < B_0/2$ is satisfied.

Further, the noise power at the output of the adaptive bandpass filter 2 is shown:

$$N_T = 2 \int_0^{B_0/2} T(f)df \tag{4}$$

Accordingly, the ratio C/N at the output of the adaptive bandpass filter 2 is:

$$C/N = P_T/N_T$$

According to the present invention, when the input signal level is sufficiently high, only the reference bandpass filter 8 restricts the bandwidth of the reception signal to $B_0$. When the input signal level decreases, and the carrier-to-noise ratio $C/N(= P_0'/N_0)$ at the output of the reference bandpass filter 8 approaches the threshold level, the adaptive bandpass filter 2 is controlled to have the particular transfer function T(f), and satisfy the inequality below.

$$P_T/N_T > P_0'/N_0 \tag{5}$$

In this case, the threshold level is improved by $\eta$:

$$\eta = P_T/N_T(N_0/P_0') \tag{6}$$

Then, the threshold $C_t$ in Fig. 2 is improved to $C_t'$, and the signal-to-noise ratio S/N of the demodulated signal is also improved by $\Delta S$. The effect of the improvement of a picture quality is considerably large, since the deterioration of the picture quality is large when the signal level is less than the threshold level $C_t$. By use of the present invention, the spike noise on the television screen decreases considerably, and an excellent picture quality is obtained.

Next, the improvement of a commercial television signal is described in detail.

4

It is assumed that a color television signal has a frequency shift up to 6 MHz, and the emphasis system recommended by CCIR. REC. 405-1 is used. The picture signal process by a pre-emphasis circuit in a transmit side has the power weights about $-10$ dB for low frequency component, and about $+3$ dB for high frequency component. Therefore, it is enough to analyze the color sub-carrier component (3.58 MHz) as the modulation signal having the highest frequency shift in a television signal.

A color bar signal in a standard test pattern has the frequency shift 6 MHz (modulation frequency is 3.58 MHz), when a pre-emphasis is utilized. The frequency shift by other picture components is considerably small as compared with that value.

The highest modulation index $m_f$ for that color bar signal is:

$$m_f=6/3.58=1.67$$

The bandwidth $B_0$ of the reference bandpass filter 8 is determined to be:

$$B_0=2(6+4.2)=20.4 \text{ MHz}$$

The output signal $P_0'$ of the reference bandpass filter 8 is shown:

$$P_0'=J_0^2(m_f)+2J_1^2(m_f)+2J_2^2(m_f)$$

$$=0.172+0.663+0.150=0.985 \qquad (7)$$

The first term of the equation (7) shows the center frequency component (carrier component) of an FM signal, the second term of the equation (7) shows the first sideband component which is separated by 3.58 MHz from the center frequency, and the third term shows the second sideband component which is separated by 7.16 MHz from the center frequency.

On the other hand, the noise power $N_0$ at the output of the reference bandpass filter is shown below:

$$N_0=B_0=20.4 \qquad (8)$$

where the noise power density is normalized by 1/MHz. Accordingly,

$$P_0'/N_0=0.985/20.4 \qquad (9)$$

The spectrum of a television signal with the above analysis is shown in Fig. 4.

Next, it is supposed that the adaptive bandpass filter 2 has the characteristics as shown by the curve (a) which has a narrow passband (b) and infinite attenuation outside of the passband. In this case, the ratio of $P_T$ (signal power) to $N_T$ (noise power), and the improvement ($\eta$) of C/N at the output of the adaptive bandpass filter are shown below.

1) when $14.32 < b < 20.4$:

$$P_T/N_T=0.985/b$$

$$1 < \eta < 1.42$$
$$(1.5 \text{ dB})$$

2) when $7.16 < b < 14.32$ is satisfied:

$$1.20 < \eta < 2.41$$
$$(0.8 \text{ dB}) \quad (3.8 \text{ dB})$$

3) when $b < 7.16$ is satisfied, demodulation is impossible, since all the spectrum of a television signal is deleted.

Next, the case that the adaptive bandpass filter 2 has the characteristics shown by the curve (b) in Fig. 4 is described. The bandpass filter with the characteristics of the curve (b) is implemented by the circuit of Fig. 5, which has fixed inductance L, a fixed capacitor C and a variable resistor R. A resistor r represents the loss included in the capacitor C and the inductor L. The variable resistor R is implemented by a PIN diode, or a Schottky diode.

When the input signal level is high enough, the resistor R is controlled to be high enough, and therefore, the filter 2 does not operate on the input signal at all, and the bandwidth of the signal is merely restricted by the reference bandpass filter 8 to $B_0$.

As the input signal level is decreased, and the value C/N becomes close to the threshold level, the resistor R of the adaptive bandpass filter 2 is controlled to be low so that the adaptive bandpass filter 2 affects the input signal. When the resistor R is adjusted properly, the transfer function T(f) of the single resonance circuit of Fig. 5 is approximately shown below:

$$T(f)=1/(1+(2f/b_0)^2) \qquad (10)$$

where $b_0$ is the bandwidth with the 3 dB level difference. The curve (b) in Fig. 4 shows the characteristics of the adaptive bandpass filter of Fig. 5.

The signal power $P_T$ and the noise power $N_T$ at the output of the adaptive bandpass filter with the characteristics of curve (b) are shown by the equations (11) and (12).

$$P_T=0.172+0.663/(1+(7.16/b_0)^2)+0.150/(1+(14.32/b_0)^2) \qquad (11)$$

$$N_T=2 \int_0^{B_0/2} 1/(1+(2f/b_0))df=b_0\tan^{-1}(B_0/b_0) \qquad (12)$$

Since $B_0$ is 20.4 MHz, said $N_T$ is calculated as follows:

$$N_T=b_0 \ \tan^{-1}(20.4/b_0) \qquad (12)'$$

Accordingly, the improvement ($\eta$) of the ratio C/N by the adaptive bandpass filter is:

$$\eta=P_T/N_T(N_0/P_0') \qquad (13)$$

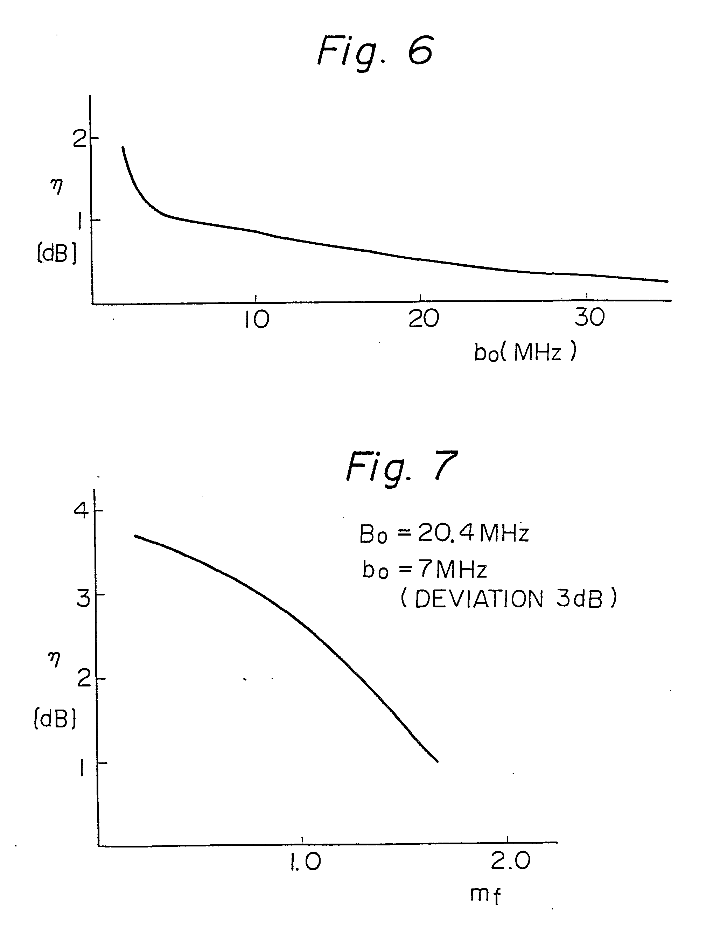

Fig. 6 shows the curve of ($\eta$) which is the improvement of the value C/N for the bandwidth $b_0$ with the 3 dB level difference. It should be noted in Fig. 6 that the value C/N is always improved for all values of $b_0$, by using a simple adaptive bandpass filter as shown in Fig. 5.

Usually, the amplitude of the color sub-carrier component of a color television signal is low, and in that case, most of the power of the television signal modulated in FM system is concentrated around the carrier frequency and within the first sidebands, and therefore, the present invention improves considerably the picture quality by deleting noise power but maintaining most of the power of the picture signal.

Fig. 7 shows the curve between the modulation index $m_f$ of the color sub-carrier component and the improvement of the quality ($\eta$) when the bandwidth $b_0$ of the adaptive bandpass filter 2 is 7 MHz.

Next, the satellite communication system in which the highest frequency shift is 10.75 MHz, and the highest modulation frequency is 4.2 MHz, is analyzed. In this case, an adaptive bandpass filter of Fig. 5 is utilized. The modulation index $m_f$ of the color sub-carrier component is $m_f=10.75/3.58=3.0$, and the bandwidth $B_0$ of the reference bandpass filter is

$$B_0=2(10.75+4.2)=29.9 \ \text{MHz}.$$

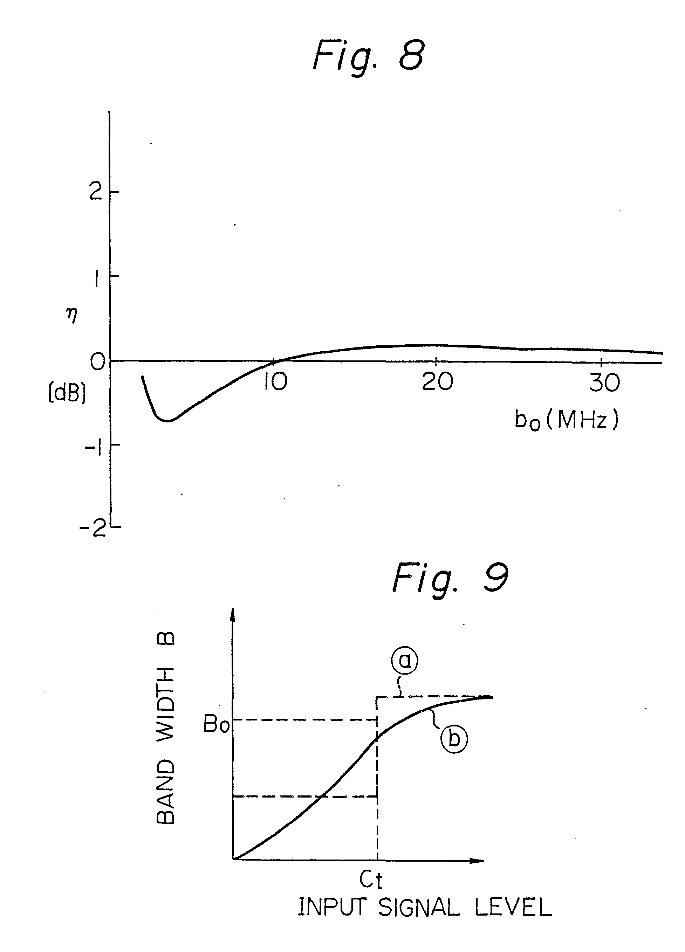

The improvement of ($\eta$) in this case is shown in Fig. 8, where the horizontal axis shows the bandwidth $b_0$ with the 3 dB difference of the adaptive bandpass filter. As apparent from Fig. 8, the value ($\eta$) is negative when the value $b_0$ is less than 10 MHz, and therefore, the value C/N is not improved in this case. The difference of Fig. 6 which improves the value C/N, and Fig. 8 which does not improve the value C/N comes from the relationship between the modulation index of a picture signal (in particular, the color sub-carrier component), and the bandwidth $b_0$ of the adaptive bandpass filter.

The present invention is effective, in particular, in a direct broadcasting satellite television system by using a simple adaptive bandpass filter as shown in Fig. 5, and the effectiveness of the present invention depends upon the relationship between the modulation index ($m_f$) and the bandwidth of the filter.

Fig. 9 shows two curves of an adaptive bandpass filter 2. The curve (a) of Fig. 9 shows the case that the bandwidth $b_0$ of the adaptive bandpass filter changes suddenly when the input signal level crosses the threshold level $C_t$, and when the input level is higher than $C_t$, the bandwidth $b_0$ is wider than $B_0$, and when the input level is lower than $C_t$, the bandwidth $b_0$ is narrower than $B_0$. The curve (b) of Fig. 9 shows the case that the bandwidth of the adaptive bandpass filter changes gradually with the change of the input signal level. Since a sudden change of the bandwidth might cause distortion of the demodulated picture signal and/or the picture quality, the smooth curve (b) is preferable.

The slope of the curve (b) of Fig. 9, or the ratio of the change of the bandwidth $b_0$ for the change of the input signal level is designed according to the characteristics of the level detector (or the detector for detecting the value C/N), and the desired picture quality. The signal level for controlling the adaptive bandpass filter is derived, for instance, from an AGC control voltage (A) at the output of the reference bandpass filter 8, or some noise component (B) at the output of the discriminator 3.

In the above embodiment, the combination of the reference bandpass filter 8 and the adaptive bandpass filter 2 is described. Alternatively, said reference bandpass filter can be removed, and merely the adaptive bandpass filter can provide the effect of the present invention.

As described above, the present invention has a first reference bandpass filter which has a fixed bandwidth, and a second adaptive bandpass filter which has a variable bandwidth. The bandwidth of the latter is wider when the input signal level is higher than the threshold level, and narrower than the bandwidth $B_0$ of the reference bandpass filter when the input signal level is equal to or lower than the

6

threshold level. The bandwidth of the adaptive bandpass filter is adjusted according to the total power of the input signal level itself, or some noise component of the output, stepwise or smoothly. Thus, the ratio C/N or S/N at the output of the adaptive bandpass filter is considerably improved, and hence the value S/N of the demodulated picture signal is improved. Spike noise which would spoil the picture quality is reduced, and the picture signal of the television transmission is improved.

The system of the present invention is useful, in particular, for a direct satellite broadcasting system in which the input signal level to each receiver set is very low, because the system improves the value C/N.

**Claims**

1. An FM signal demodulation system comprising an input (6) to receive an FM signal; detection means (1) for providing a control signal dependent upon the level of the FM signal; an adaptive bandpass filter (2) coupled to the input, the bandwidth of which filter is controlled by the control signal from the detection means; and a frequency discriminator (3) coupled to the output of the adaptive bandpass filter for demodulating the FM signal to provide a demodulated signal; characterised in that the adaptive bandpass filter has a fixed centre frequency; in that the detection means detects the signal-to-noise ratio of the demodulated signal to provide the control signal; and in that the adaptive bandpass filter responds to the signal-to-noise ratio detected by the detection means so that the bandwidth is narrow when said signal-to-noise ratio is low, and the bandwidth is wide when said signal-to-noise ratio is high.

2. A system according to claim 1, characterised in that a reference bandpass filter (8) having a fixed bandwidth is connected between the system input (6) and the input of the adaptive bandpass filter (2).

3. A system according to claim 2, characterised in that the bandwidth of the adaptive bandpass filter (2) is wider than that of the reference bandpass filter (8) when said signal-to-noise ratio is higher than a threshold signal-to-noise ratio for demodulating an FM signal defined by the bandwidth of the reference bandpass filter, and the bandwidth of the adaptive bandpass filter is narrower than that of the reference bandpass filter when said signal-to-noise ratio is lower than the threshold signal-to-noise ratio.

4. A system according to claim 1, characterised in that the detection means (1) detects the level of the total signal power of the FM signal for measuring the signal-to-noise ratio.

5. A system according to claim 1, characterised in that the detection means (1) detects a noise component of the demodulated signal for measuring the signal-to-noise ratio.

6. A system according to any preceding claim, characterised in that the adaptive bandpass filter (2) comprises a parallel circuit of an inductance (L) and a capacitance (C), and a variable resistor (R) in series with the parallel circuit.

7. A system according to claim 2, characterised in that the transfer function T(f) of the adaptive bandpass filter (2) satisfies the relationship:

$$P_0'/N_0 < P_T/N_T$$

where

a) $P_0'/N_0$ is the ratio of the modulation signal power $P_0'$ to the noise power $N_0$ at the output of the reference bandpass filter (8) having a bandwidth $B_0$ and satisfies the relationship:

$$P_0'/N_0 = (J_0^2(m_f) + 2J_1^2(m_f) + 2J_2^2(m_f) + ''' 2J_n^2(m_f) + ''')/B_0$$

b) $P_T/N_T$ is the ratio of the modulation signal power $P_T$ to the noise power $N_T$ at the output of the adaptive bandpass filter and satisfies the relationship:

$$P_T/N_T = \frac{(J_0^2(m_f) + 2J_1^2(m_f)T(f_v) + 2J_2^2(m_f)T(2f_v) + ''' + 2J_n^2(m_f)T(nf_v) + '''}{2\int_0^{B_0/2} T(j)df}$$

c) $m_f$ is the modulation index and $m_f = \Delta f/f_v$ is satisfied;

d) the bandwidth $B_0$ of the reference bandpass filter is approximately:

$$B_0 = 2(\Delta f + f_h)$$

e) $nf_v < B_0/2$ is satisfied;

f) $f_h$ is the highest modulation frequency, $f_v$ is the frequency of color sub-carrier component, $\Delta f$ is the highest frequency shift, $j_n(m_f)$ is a Bessel function, $T(0) = 1$.

**Patentansprüche**

1. FM-Signal-Demodulationssystem mit einem Eingang (6) für ein FM-Signal; einem Detektormittel (1) zum Erzeugen eines Steuersignals in Abhängigkeit vom Pegel des FM-Signals; einem mit dem Eingang verbundenen adaptiven Bandpaßfilter (2), dessen Bandbreite durch das Steuersignal aus dem Detektormittel gesteuert wird; und einem Frequenzdiskriminator (3), der mit dem Ausgang des adaptiven Bandpaßfilters zum Demodulieren des FM-Signals zur Bildung eines demodulierten Signals verbunden ist, dadurch gekennzeichnet, daß das adaptive Bandpaßfilter eine feste Mittenfrequenz aufweist; daß das Detektormittel den Rauschabstand des demodulierten Signals zur Bildung des Steuersignals feststellt; und daß das adaptive Bandpaßfilter in der Weise auf den durch das Detektormittel festgestellten Rauschabstand anspricht, daß die Bandbreite gering ist, wenn der Rauschabstand niedrig ist, und die Bandbreite groß ist, wenn der Rauschabstand hoch ist.

2. System nach Anspruch 1, dadurch gekennzeichnet, daß ein Bezugsbandpaßfilter (8) mit fester Bandbreite zwischen den Systemeingang (6) und den Eingang des adaptiven Bandpaßfilters (2) geschaltet ist.

3. System nach Anspruch 2, dadurch gekennzeichnet, daß die Bandbreite des adaptiven Bandpaßfilters (2) größer als die des Bezugsbandpaßfilters (8) ist, wenn der Rauschabstand größer als ein Schwellenrauschabstand zur Demodulation eines durch die Bandbreite des Bezugsbandpaßfilters begrenzten FM-Signals ist, und die Bandbreite des adaptiven Bandpaßfilters kleiner als die des Bezugsbandpaßfilters ist, wenn der Rauschabstand kleiner als der Schwellenrauschabstand ist.

4. System nach Anspruch 1, dadurch gekennzeichnet, daß das Detektormittel (1) den Pegel der gesamten Signalleistung des FM-Signals zum Messen des Rauschabstands feststellt.

5. System nach Anspruch 1, dadurch gekennzeichnet, daß das Detektormittel (1) eine Rauschkomponente des demodulierten Signals zum Messen des Rauschabstands festellt.

6. System nach einem der vorhergehenden Ansprüche, dadurch gekennzeichnet, daß das adaptive Bandpaßfilter (2) eine Parallelschaltung aus einer Induktivität (L) und einer Kapazität (C) und einen veränderbaren ohmschen Widerstand (R) in Reihe mit der Parallelschaltung aufweist.

7. System nach Anspruch 2, dadurch gekennzeichnet, daß die Übertragungsfunktion T(f) des adaptiven Bandpaßfilters (2) die Beziehung

$$P_0'/N_0 < P_T/N_T$$

erfüllt wobei

a) $P_0'/N_0$ das Verhältnis der Modulationssignalleistung $P_0'$ zur Rauschleistung $N_0$ am Ausgang des Bezugsbandpaßfilters (8) mit einer Bandbreite $B_0$ ist und die Beziehung

$$P_0'/N_0 = (J_0^2(m_f) + 2J_1^2(m_f) + 2J_2^2(m_f) + ''' 2J_n^2(m_f) + ''')/B_0$$

erfüllt,

b) $P_T/N_T$ das Verhältnis der Modulationssignalleistung $P_T$ zur Rauschleistung $N_T$ am Ausgang des adaptiven Bandpaßfilters ist und die Beziehung

$$P_T/N_T = \frac{(J_0^2(m_f) + 2J_1^2(m_f)T(f_v) + 2J_2^2(m_f)T(2f_v) + ''' + 2J_n^2(m_f)T(nf_v) + '''}{2\int_0^{B_0/2} T(j)df}$$

erfüllt,

c) $m_f$ der Modulationsindex und $m_f = \Delta f/f_v$ erfüllt ist,

d) für die Bandbreite $B_0$ des Bezugsbandpaßfilters angenähert gilt:

$$B_0 = 2(\Delta f + f_h)$$

e) $nf_v < B_0/2$ erfüllt ist,

f) $f_h$ die höchste Modulationsfrequenz, $f_v$ die Frequenz der Farbhilfsträgerkomponente, $\Delta f$ die höchste Frequenzverschiebung, $J_n(m_f)$ eine Bessel-Funktion und $T(0) = 1$ ist.

**Revendications**

1. Système démodulateur de signal en modulation de fréquence FM comprenant une entrée (6) pour recevoir un signal FM; un moyen de détection (1) pour fournir un signal de réglage fonction du niveau du signal FM; un filtre passe-bande adaptatif (2) couplé à l'entrée dont la largeur de bande de ce filtre est réglée par le signal de réglage provenant du moyen de détection; et un discriminateur de fréquence (3) couplé à la sortie du filtre passe-bande adaptatif pour démoduler le signal FM pour fournir un signal démodulé; caractérisé en ce que le filtre passe-bande adaptatif a une fréquence centrale fixe; en ce que le moyen de détection détecte le rapport signal/bruit du signal démodulé pour fournir le signal de réglage; et en ce que le filtre passe-bande adaptatif répond au rapport signal/bruit détecté par le moyen de détection

8

de sorte que la largeur de bande est étroite quand le rapport signal/bruit est faible, et que la largeur de bande est large quand le rapport signal/bruit est élevé.

2. Système selon la revendication 1, caractérisé en ce qu'un filtre passe-bande de référence (8) ayant une largeur de bande fixe est connecté entre l'entrée de système (6) et l'entrée du filtre passe-bande adaptatif (2).

3. Système selon la revendication 2, caractérisé en ce que la largeur de bande du filtre passe-bande adaptatif (2) est plus large que celle du filtre passe-bande de référence (8) quand le rapport signal/bruit est supérieur à un rapport signal/bruit de seuil pour démoduler un signal FM défini par la largeur de bande du filtre passe-bande de référence, et en ce que la largeur de bande du filtre passe-bande adaptatif est plus étroite que celle du filtre passe-bande de référence quand le rapport signal/bruit est inférieur au rapport signal/bruit de seuil.

4. Système selon la revendication 1, caractérisé en ce que le moyen de détection (1) détecte le niveau de la puissance de signal totale du signal FM pour mesurer le rapport signal/bruit.

5. Système selon la revendication 1, caractérisé en ce que le moyen de détection (1) détecte une composante de bruit du signal démodulé pour mesurer le rapport signal/bruit.

6. Système selon l'une quelconque des revendications 1 à 5, caractérisé en ce que le filtre passe-bande adaptatif (2) comprend un circuit parallèle d'une inductance (L) et d'une capacité (C), et une résistance variable (R) en série avec le circuit parallèle.

7. Système selon la revendication 2, caractérisé en ce que la fonction de transfert T(f) du filtre passe-bande adaptatif (2) satisfait la relation:

$$P'_0/N_0 < P_T/N_T$$

où

a) $P'_0/N_0$ est le rapport de la puissance de signal de modulation $P'_0$ à la puissance de bruit $N_0$ à la sortie du filtre passe-bande de référence (8) ayant une largeur de bande $B_0$ et qui satisfait la relation:

$$P'_0/N_0 = (J_0^2(m_f) + 2J_1^2(m_f) + 2J_2^2(m_f) + \ldots + 2J_n^2(m_f) + \ldots)/B_0$$

b) $P_T/N_T$ est le rapport de la puissance de signal de modulation $P_T$ à la puissance de bruit $N_T$ à la sortie du filtre passe-bande adaptatif et qui satisfait la relation:

$$P_T/N_T = \frac{(J_0^2(m_f) + 2J_1^2(m_f)T(f_v) + 2J_2^2(m_f)T(2f_v) + \ldots + 2J_n^2(m_f)T(nf_v) \ldots}{2\int_0^{B_0/2} T^2(j)df}$$

c) $m_f$ est le facteur de modulation et $m_f = \Delta f/f_v$ est satisfaite;

d) la largeur de bande $B_0$ du filtre passe-bande de référence est à peu près:

$$B_0 = 2(\Delta f + f_h)$$

e) $nf_v < B_0/2$ est satisfaite;

f) $f_h$ est la fréquence de modulation la plus élevée, $f_v$ est la fréquence de la composante sous-porteuse de couleur, $\Delta f$ est le décalage de fréquence le plus élevé, $J_n(m_f)$ est une fonction de Bessel, $T(0) = 1$.

# Fig. 1

# Fig. 2

*Fig. 3*

*Fig. 4*

*Fig. 5*

# Fig. 6

# Fig. 7

$B_0 = 20.4\,MHz$

$b_0 = 7\,MHz$
   ( DEVIATION 3dB )

# Fig. 8

# Fig. 9